# EUROPÄISCHE PATENTSCHRIFT

(11) **EP 3 400 389 B1**
(45) Veröffentlichungstag und Bekanntmachung des Hinweises auf die Patenterteilung: **04.03.2026**
(21) Anmeldenummer: 17728516.0
(22) Anmeldetag: 01.06.2017
(51) Int. Cl.: F04D 19/04, F04B 37/02, F04D 29/02, C23C 14/35

(54) **TURBOMOLEKULARPUMPE UND VERFAHREN ZUR BESCHICHTUNG VON BAUTEILEN EINER TURBOMOLEKULARPUMPE**
TURBOMOLECULAR PUMP AND METHOD FOR COATING COMPONENTS OF A TURBOMOLECULAR PUMP
POMPE TURBOMOLÉCULAIRE ET PROCÉDÉ DE REVÊTEMENT DE COMPOSANTS D'UNE POMPE TURBOMOLÉCULAIRE

(30) Priorität: 03.06.2016 DE 102016110357; 30.11.2016 DE 102016123146
(43) Veröffentlichungstag der Anmeldung: 14.11.2018
(73) Patentinhaber: Pfeiffer Vacuum Components & Solutions GmbH, 37081 Göttingen (DE); Movatec GmbH, 87437 Kempten (DE)
(72) Erfinder: LAUER, Thorsten, 85411 Hohenkammer (DE); KRAFT, Andreas, 56462 Höhn-Oellingen (DE)
(74) Vertreter: Manitz Finsterwald Patent- und Rechtsanwaltspartnerschaft mbB
(86) Internationale Anmeldenummer: PCT/EP2017/063343
(87) Internationale Veröffentlichungsnummer: WO 2017/207706

(56) Entgegenhaltungen:
- EP-A1- 2 071 188
- EP-A2- 2 574 785
- WO-A1-2014/182333
- US-A1- 2006 096 857
- US-B1- 6 468 043
- PRODROMIDES ALEXANDRA: "Non-Evaporable Getter Thin Film Coatings for Vacuum Applications", 31 December 2002 (2002-12-31), XP055809654, Retrieved from the Internet <URL:https://cds.cern.ch/record/593236/files/thesis-2002-042.pdf> [retrieved on 20210601]
- BENVENUTI C ET AL: "Vacuum properties of palladium thin film coatings", VACUUM, PERGAMON PRESS, GB, vol. 73, no. 2, 19 March 2004 (2004-03-19), pages 139 - 144, XP002327155, ISSN: 0042-207X, DOI: 10.1016/J.VACUUM.2003.12.022

## Beschreibung

Die Erfindung betrifft ein Vakuumgerät, das zumindest teilweise mit einer Schicht eines NEG-Materials beschichtet ist (NEG = Non-Evaporable Getter). Des Weiteren betrifft die Erfindung Verfahren zum NEG-Beschichten von Bauteilen von Vakuumgeräten. Bei dem Vakuumgerät handelt es sich um eine Turbomolekularvakuumpumpe. Schichten bzw. Beschichtungen, die dazu in der Lage sind, Gasteilchen zu absorbieren, sind grundsätzlich bekannt. Insbesondere sind NEG-Beschichtungen sowie Drahtbeschichtungsverfahren zur Herstellung derartiger Beschichtungen grundsätzlich bekannt.

Zum Stand der Technik wird allgemein verwiesen auf DE 697 19 507 T2, DE 698 17 775 T2, DE 600 00 873 T2 sowie WO 2003/074753 A1. In dem Artikel "Vacuum properties of palladium thin film coatings" von C. Benvenuti et al. (Vacuum; Pergamon Press, Bd. 73, Nr. 2, Seiten 139-144) wird die Möglichkeit erwähnt, eine Turbomolekularvakuumpumpe mit einer NEG-Beschichtung zu versehen.

Aufgabe der Erfindung ist es, Vakuumgeräte insbesondere hinsichtlich ihrer Leistungsfähigkeit zu verbessern sowie verbesserte Verfahren zur Herstellung von gasabsorbierenden Schichten bzw. Beschichtungen zu schaffen.

Die Lösung dieser Aufgabe erfolgt jeweils durch die Merkmale der unabhängigen Ansprüche.

Erfindungsgemäß umfasst die Turbomolekularpumpe zumindest ein Bauteil, das einen Abschnitt aufweist, der bei einem Betrieb der Pumpe mit einem Vakuum in Kontakt steht und der zumindest abschnittsweise mit einer Gasteilchen (z.B. Atome, Moleküle, lonen) absorbierenden Schicht beschichtet ist, und zwar mit einer Schicht eines non-evaporable getter (NEG) Materials.

Mit der Schicht werden zwei vorteilhafte Effekte erzielt. Einerseits reduziert oder verhindert die Beschichtung das Ausgasen des beschichteten Bauteils (passive Wirkung der Schicht). Andererseits kann in einem aktivierten Zustand des Materials der Schicht durch deren Gasabsorption eine Pumpwirkung bereit gestellt werden (aktive Wirkung der Schicht). D.h. die Schicht trägt nicht nur zu dem Erhalt des Vakuums bei, sondern sie reduziert durch die Aufnahmen von Gasteilchen sogar den herrschenden Druck aktiv. Gerade bei Geräten, die im Ultrahochvakuumbereich (UHV) zum Einsatz gelangen, ist die vorstehend beschriebene Doppelwirkung der Schicht von großem Vorteil.

Grundsätzlich ist eine möglichst großflächige Beschichtung der mit dem Vakuum in Kontakt stehenden Oberflächen des Geräts erstrebenswert. In vielen Fällen ist es aber - auch vor dem Hintergrund der damit verbundenen Herstellungskosten - ausreichend, nur bestimmte Bauteile oder Oberflächenabschnitte zu beschichten. Die Schicht umfasst Titan, Zirkonium und/oder Vanadium. Insbesondere umfasst sie im Wesentlichen nur Titan, Zirkonium und/oder Vanadium. Bei einer Mischung von Titan, Zirkonium und Vanadium sind Titan und Vanadium zu in etwa gleich großen Anteilen vorgesehen. Außerdem enthält die Schicht weniger Zirkonium als Titan und/oder Vanadium. Beispielsweise liegen Titan, Zirkonium und Vanadium in einem Mischungsverhältnis von etwa 34:32:34 vor. Grundsätzlich sind aber auch NEG-Materialien bekannt und erfindungsgemäß einsetzbar, die die genannten Elemente in anderen Mischungsverhältnissen und/oder weitere Elemente oder Stoffe umfassen.

Das Bauteil kann ein bei Betrieb der Turbomolekularpumpe (im Folgenden auch als Gerät bezeichnet) statisches Bauteil sein. Insbesondere ist es ein Gehäuse und/oder ein mit einem Gehäuse fest verbundenes Bauteil. Beispielsweise ist die innere Oberfläche des Gehäuse oder einzelner Gehäuseteile teilweise oder im Wesentlichen vollständig mit NEG-Material beschichtet. Es können auch Statorscheiben und Statordistanzringe entsprechend beschichtet sein.

Das Bauteil kann auch ein bei Betrieb des Geräts zu einer Bewegung antreibbares Bauteil sein, beispielsweise ein eine Pumpwirkung erzeugendes Bauteil, wie etwa eine Rotorscheibe.

Es ist besonders wirkungsvoll, wenn ein Einlassbereich der Pumpe und/oder in dem Einlassbereich der Pumpe angeordnete Komponenten zumindest abschnittsweise mit der Schicht beschichtet sind. Grundsätzlich ist es auch denkbar, einem direkten Einlassbereich der Pumpe vorgeschaltete Komponenten abschnittsweise oder vollständig zu beschichten. Analoges gilt auch für andere Vakuumgeräte.

Bei einem ersten erfindungsgemäßen Verfahren erfolgt das NEG-Beschichten einer Turbomolekularpumpe gemäß zumindest einer der vorstehend beschriebenen Ausführungsformen durch einen Sputterprozess, insbesondere durch Magnetronsputtern, wobei wenigstens ein nicht-drahtförmiges Target verwendet wird.

Bei einem zweiten erfindungsgemäßen Verfahren erfolgt das NEG-Beschichten einer Turbomolekularpumpe gemäß zumindest einer der vorstehend beschriebenen Ausführungsformen durch einen Sputterprozess, insbesondere durch Magnetronsputtern, wobei das Target und das Bauteil während des Sputterprozesses relativ zueinander bewegt werden. Die Relativbewegung kann derart erfolgen, dass entweder das Target ruht und das Bauteil bewegt wird, oder dass das Bauteil ruht und das Target bewegt wird.

Diese beiden erfindungsgemäßen Verfahren - und auch deren Ausgestaltungen und Weiterbildungen - können grundsätzlich beliebig miteinander kombiniert werden.

Auf die allgemeinen, bekannten Eigenschaften von NEG-Beschichtungen sowie auf die Technik des Sputterns und insbesondere des Magnetronsputterns braucht nicht näher eingegangen zu werden, da dies dem Fachmann grundsätzlich bekannt ist und zum allgemeinen Fachwissen gehört.

Eine Besonderheit des ersten Aspektes der Erfindung liegt darin, dass kein Drahtbeschichtungsverfahren zum Einsatz kommt, sondern dass das Target der Sputter-Einrichtung gezielt in Abhängigkeit von dem jeweils zu beschichtenden Bauteil bzw. einer zu beschichtenden Oberfläche des jeweiligen Bauteils ausgebildet bzw. geformt ist. Hierauf wird nachstehend näher eingegangen.

Eine Besonderheit des zweiten Aspektes der Erfindung besteht darin, dass kein statischer Sputterprozess durchgeführt wird, sondern dass sich das Target der Sputtereinrichtung und das jeweils zu beschichtende Bauteil (Substrat) während des Sputterprozesses relativ zueinander bewegen. Das Target und das zu beschichtende Bauteil können dabei beliebige Formen aufweisen. Es wurde gefunden, dass sich der Beschichtungsvorgang durch die Relativbewegung zwischen Substrat und Target dramatisch beschleunigen lässt. Beispielsweise bei der Beschichtung eines Rohres mit einer Länge von 1 m mit einer NEG-Beschichtung mit einer Dicke von 1 µm ließ sich die erforderliche Zeitdauer für den Beschichtungsvorgang von etwa 2 bis 3 Tagen bei einem Drahtbeschichtungsverfahren auf etwa 10 bis 12 Stunden bei dem erfindungsgemäßen Verfahren reduzieren.

Gemäß einer Ausführungsform der beiden erfindungsgemäßen Verfahren kann ein Target verwendet werden, dass eine zumindest abschnittsweise, insbesondere vollständig ebene Targetoberfläche aufweist (im Folgenden ebenes Target genannt). Insbesondere kann mittels eines solchen ebenen Targets ein rohrförmiges Bauteil NEG-beschichtet werden. Bevorzugt ist das ebene Target während des Sputterprozesses derart relativ zu dem rohrförmigen Bauteil orientiert, dass der äußere Rand des Targets in einer senkrecht zur Längsachse des rohrförmigen Bauteils verlaufenden Ebene liegt. Der Durchmesser des ebenen Targets kann in Abhängigkeit vom Innendurchmesser des Bauteils entsprechend skaliert werden. In einem anderen Ausführungsbeispiel kann ein ebenes und verfahrbar angeordnetes Target verwendet werden, um plattenförmige Bauteile oder Bauteile mit ebenen Abschnitten vergleichsweise schnell mit NEG-Beschichtungen zu versehen.

Ein erfindungsgemäßes Vakuumgerät kann aus mehreren erfindungsgemäß beschichteten Bauteilen zusammengesetzt werden. Beispielsweise lassen sich aus erfindungsgemäß beschichteten plattenförmigen oder rohrförmigen Bauteilen Vakuumgefäße zusammensetzen. Dies gilt grundsätzlich auch für Vakuumkammern und Bauteile einer Vakuumanlage, z.B. Rohre (nicht Teil der Erfindung).

Es ist vorgesehen, dass das Target eine Legierung umfasst oder aus einer Legierung besteht, die Titan, Zirkonium und Vanadium enthält. In einer möglichen Zusammensetzung dieser Legierung sind deren Bestandteile zumindest ungefähr zu gleichen Teilen enthalten. In einer besonders bevorzugten Ausgestaltung enthält die Legierung Titan, Zirkonium und Vanadium im Verhältnis 34:32:34.

Des Weiteren ist bevorzugt vorgesehen, dass eine NEG-Beschichtung erzeugt wird, die Titan, Zirkonium und Vanadium im Verhältnis 34:32:34 enthält.

Es wurde gefunden, dass eine erfindungsgemäß hergestellte NEG-Beschichtung durch Erhitzen aktivierbar und in einem aktivierten Zustand dazu in der Lage ist, an ihrer Oberfläche Restgasatome zu binden.

Ferner wurde gefunden, dass erfindungsgemäß eine NEG-Beschichtung herstellbar ist, die nach einem erneuten Aktivieren dazu in der Lage ist, zuvor an ihrer Oberfläche gebundene Restgasatome zu desorbieren und/oder in das Innere der NEG-Beschichtung wandern zu lassen. Insbesondere wird der größte Teil der Restgasatome desorbiert und nur ein kleiner Teil der Restgasatome wandert in das Innere der Beschichtung. Der desorbierte Anteil kann bei einer erneuten Aktivierung durch zusätzliche (mechanische) Pumpen komplett abgepumpt und aus dem Vakuumvolumen entfernt werden.

Des Weiteren wurde gefunden, dass erfindungsgemäß eine NEG-Beschichtung herstellbar ist, die in einem unaktivierten Zustand eine Ausgasrate aufweist, die zwischen 10⁻¹⁴ und 10⁻¹⁵ mbar * I * s⁻¹ * cm⁻² beträgt.

Des Weiteren wurde gefunden, dass erfindungsgemäß eine NEG-Beschichtung herstellbar ist, mittels der in einem geschlossenen Raum ohne zusätzliche Pumpwirkung, also ohne Zuhilfenahme einer zusätzlichen Pumpeinrichtung, ein Druck von weniger als 5 x 10⁻¹¹ mbar erreichbar ist.

Des Weiteren kann erfindungsgemäß vorgesehen sein, dass der Sputterprozess derart durchgeführt wird, dass auf einer zu beschichtenden Oberfläche des jeweiligen Bauteils vorhandene Fremdatome durch die Sputteratome entfernt werden.

Bei dem erfindungsgemäßen Verfahren zum Betreiben einer Turbomolekularpumpe, ist vorgesehen, dass zumindest das mit der NEG-Beschichtung versehene Bauteil vor der erfindungsgemäßen Verwendung des Vakuumgeräts durch Erhitzen aktiviert wird.

Dabei kann vorgesehen sein, dass das Bauteil auf ungefähr oder genau 200°C erhitzt wird. Über oder unter diesem Temperaturwert liegende Temperaturen sind ebenfalls möglich. Insbesondere wurde gefunden, dass bei einer Aktivierung des Bauteils bei ungefähr oder genau 200°C eine Pumpwirkung der Oberfläche eintritt, so dass Drücke von weniger als 5 x 10⁻¹¹ mbar erreichbar sind. Insbesondere wurde aber auch gefunden, dass bei einer teilweisen Aktivierung des Bauteils bei ungefähr oder genau 80°C eine teilweise Pumpwirkung der Oberfläche eintritt, so dass Drücke von weniger als 5 x 10⁻⁹ mbar erreichbar sind.

Des Weiteren kann vorgesehen sein, dass das Bauteil über einen Zeitraum von zumindest im Wesentlichen 24 Stunden auf einer Temperatur gehalten wird, die ungefähr oder genau 200°C beträgt, wobei über oder unter diesem Temperaturwert liegende Temperaturen ebenfalls möglich sind.

Es wurde gefunden, dass im Anschluss an eine Betriebsphase eines Vakuumgerätes mit zuvor aktivierter NEG-Beschichtung die während des Betriebs an der Oberfläche der NEG-Beschichtung gebundenen Restgasatome desorbieren und/oder in das Innere der NEG-Beschichtung wandern, wenn die NEG-Beschichtung nach der jeweiligen Betriebsphase erneut aktiviert wird. Die NEG-Beschichtung bzw. das jeweilige Bauteil wird folglich nicht nach einmaliger Verwendung unbrauchbar. Vielmehr kann ohne über ein erneutes Aktivieren hinausgehende Zusatzmaßnahmen die Einsatzbereitschaft des Vakuumgerätes wiederhergestellt werden.

Nachfolgend wird die Erfindung beispielhaft anhand vorteilhafter Ausführungsformen unter Bezugnahme auf die beigefügten Figuren beschrieben. Es zeigen, jeweils schematisch:
- Fig. 1: eine perspektivische Ansicht einer Turbomolekularpumpe,
- Fig. 2: eine Ansicht der Unterseite der Turbomolekularpumpe von Fig. 1,
- Fig. 3: einen Querschnitt der Turbomolekularpumpe längs der in Fig. 2 gezeigten Schnittlinie A-A,
- Fig. 4: eine Querschnittsansicht der Turbomolekularpumpe längs der in Fig. 2 gezeigten Schnittlinie B-B,
- Fig. 5: eine Querschnittsansicht der Turbomolekularpumpe längs der in Fig. 2 gezeigten Schnittlinie C-C,
- Fig. 6: eine perspektivische Ansicht eines Magnetronsputterkopfes zur NEG-Beschichtung von Bauteilen, insbesondere rohrförmigen Bauteilen,
- Fig. 7: einen Querschnitt des in Fig. 6 gezeigten Magnetronsputterkopfes und
- Fig.8: eine Prinzip-Skizze des Aufbaus einer Anlage zur NEG-Beschichtung rohrförmiger Bauteile mit einem Sputterkopf (unten) bzw. zwei Sputterköpfen (oben),

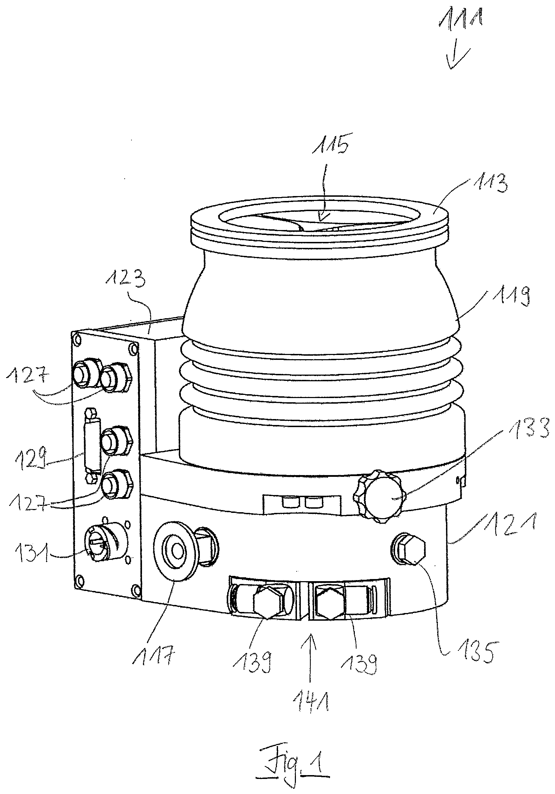

Die in Fig. 1 gezeigte Turbomolekularpumpe 111 umfasst einen von einem Einlassflansch 113 umgebenen Pumpeneinlass 115, an welchen in an sich bekannter Weise ein nicht dargestellter Rezipient angeschlossen werden kann. Das Gas aus dem Rezipienten kann über den Pumpeneinlass 115 aus dem Rezipienten gesaugt und durch die Pumpe hindurch zu einem Pumpenauslass 117 gefördert werden, an den eine Vorvakuumpumpe, wie etwa eine Drehschieberpumpe, angeschlossen sein kann.

Der Einlassflansch 113 bildet bei der Ausrichtung der Vakuumpumpe gemäß Fig. 1 das obere Ende des Gehäuses 119 der Vakuumpumpe 111. Das Gehäuse 119 umfasst ein Unterteil 121, an welchem seitlich ein Elektronikgehäuse 123 angeordnet ist. In dem Elektronikgehäuse 123 sind elektrische und/oder elektronische Komponenten der Vakuumpumpe 111 untergebracht, z.B. zum Betreiben eines in der Vakuumpumpe angeordneten Elektromotors 125. Am Elektronikgehäuse 123 sind mehrere Anschlüsse 127 für Zubehör vorgesehen. Außerdem sind eine Datenschnittstelle 129, z.B. gemäß dem RS485-Standard, und ein Stromversorgungsanschluss 131 am Elektronikgehäuse 123 angeordnet.

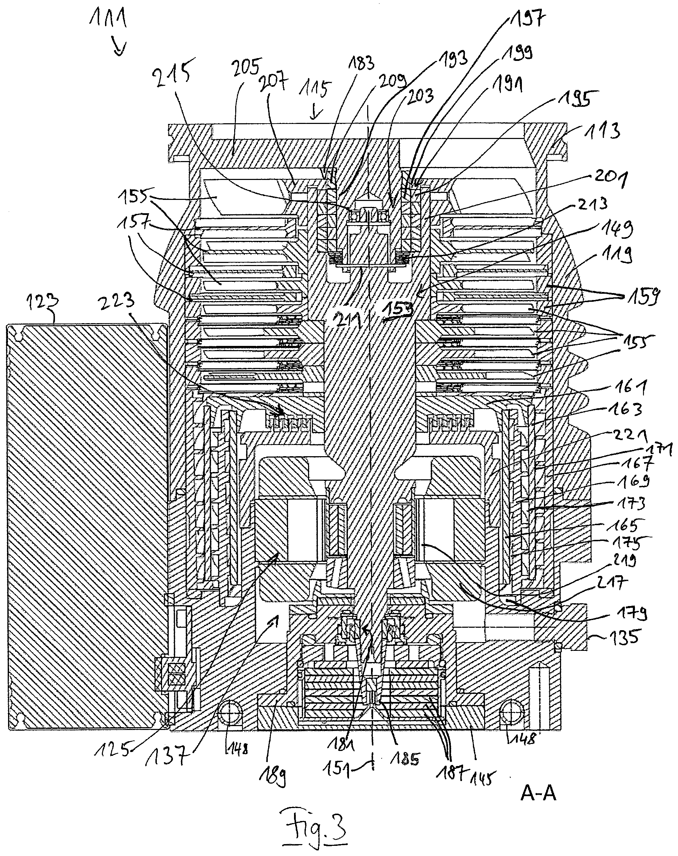

Am Gehäuse 119 der Turbomolekularpumpe 111 ist ein Fluteinlass 133, insbesondere in Form eines Flutventils, vorgesehen, über den die Vakuumpumpe 111 geflutet werden kann. Im Bereich des Unterteils 121 ist ferner noch ein Sperrgasanschluss 135, der auch als Spülgasanschluss bezeichnet wird, angeordnet, über welchen Spülgas zum Schutz des Elektromotors 125 (siehe z.B. Fig. 3) vor dem von der Pumpe geförderten Gas in den Motorraum 137, in welchem der Elektromotor 125 in der Vakuumpumpe 111 untergebracht ist, gebracht werden kann. Im Unterteil 121 sind ferner noch zwei Kühlmittelanschlüsse 139 angeordnet, wobei einer der Kühlmittelanschlüsse als Einlass und der andere Kühlmittelanschluss als Auslass für Kühlmittel vorgesehen ist, das zu Kühlzwecken in die Vakuumpumpe geleitet werden kann.

Die untere Seite 141 der Vakuumpumpe kann als Standfläche dienen, sodass die Vakuumpumpe 111 auf der Unterseite 141 stehend betrieben werden kann. Die Vakuumpumpe 111 kann aber auch über den Einlassflansch 113 an einem Rezipienten befestigt werden und somit gewissermaßen hängend betrieben werden. Außerdem kann die Vakuumpumpe 111 so gestaltet sein, dass sie auch in Betrieb genommen werden kann, wenn sie auf andere Weise ausgerichtet ist als in Fig. 1 gezeigt ist. Es lassen sich auch Ausführungsformen der Vakuumpumpe realisieren, bei der die Unterseite 141 nicht nach unten, sondern zur Seite gewandt oder nach oben gerichtet angeordnet werden kann.

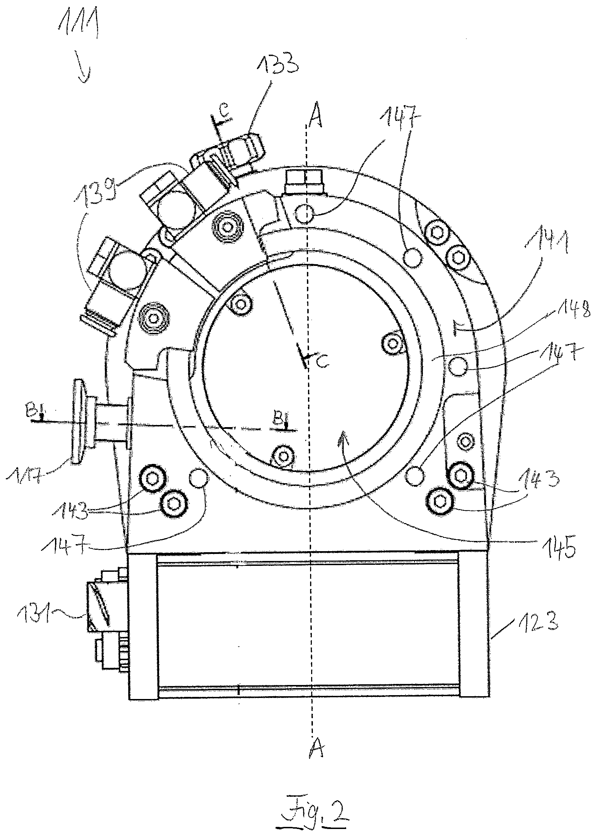

An der Unterseite 141, die in Fig. 2 dargestellt ist, sind noch diverse Schrauben 143 angeordnet, mittels denen hier nicht weiter spezifizierte Bauteile der Vakuumpumpe aneinander befestigt sind. Beispielsweise ist ein Lagerdeckel 145 an der Unterseite 141 befestigt.

An der Unterseite 141 sind außerdem Befestigungsbohrungen 147 angeordnet, über welche die Pumpe 111 beispielsweise an einer Auflagefläche befestigt werden kann.

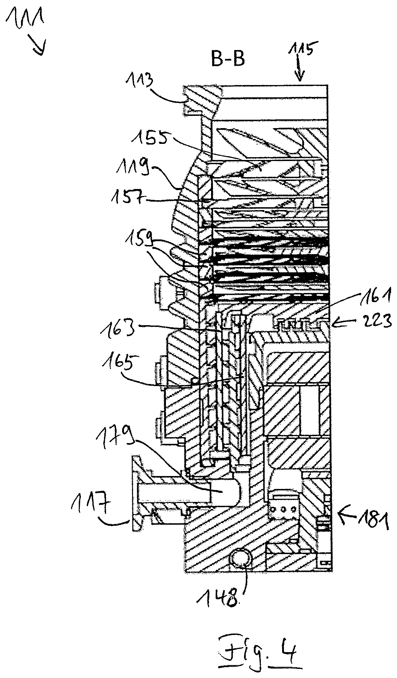

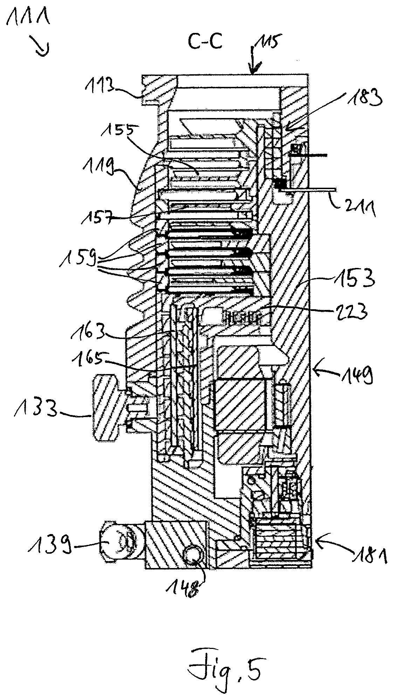

In den Figuren 2 bis 5 ist eine Kühlmittelleitung 148 dargestellt, in welcher das über die Kühlmittelanschlüsse 139 ein- und ausgeleitete Kühlmittel zirkulieren kann.

Wie die Schnittdarstellungen der Figuren 3 bis 5 zeigen, umfasst die Vakuumpumpe mehrere Prozessgaspumpstufen zur Förderung des an dem Pumpeneinlass 115 anstehenden Prozessgases zu dem Pumpenauslass 117.

In dem Gehäuse 119 ist ein Rotor 149 angeordnet, der eine um eine Rotationsachse 151 drehbare Rotorwelle 153 aufweist.

Die Turbomolekularpumpe 111 umfasst mehrere pumpwirksam miteinander in Serie geschaltete turbomolekulare Pumpstufen mit mehreren an der Rotorwelle 153 befestigten radialen Rotorscheiben 155 und zwischen den Rotorscheiben 155 angeordneten und in dem Gehäuse 119 festgelegten Statorscheiben 157. Dabei bilden eine Rotorscheibe 155 und eine benachbarte Statorscheibe 157 jeweils eine turbomolekulare Pumpstufe. Die Statorscheiben 157 sind durch Abstandsringe 159 in einem gewünschten axialen Abstand zueinander gehalten.

Die Vakuumpumpe umfasst außerdem in radialer Richtung ineinander angeordnete und pumpwirksam miteinander in Serie geschaltete Holweck-Pumpstufen. Der Rotor der Holweck-Pumpstufen umfasst eine an der Rotorwelle 153 angeordnete Rotornabe 161 und zwei an der Rotornabe 161 befestigte und von dieser getragene zylindermantelförmige Holweck-Rotorhülsen 163, 165, die koaxial zur Rotationsachse 151 orientiert und in radialer Richtung ineinander geschachtelt sind. Ferner sind zwei zylindermantelförmige Holweck-Statorhülsen 167, 169 vorgesehen, die ebenfalls koaxial zu der Rotationsachse 151 orientiert und in radialer Richtung gesehen ineinander geschachtelt sind.

Die pumpaktiven Oberflächen der Holweck-Pumpstufen sind durch die Mantelflächen, also durch die radialen Innen- und/oder Außenflächen, der Holweck-Rotorhülsen 163, 165 und der Holweck-Statorhülsen 167, 169 gebildet. Die radiale Innenfläche der äußeren Holweck-Statorhülse 167 liegt der radialen Außenfläche der äußeren Holweck-Rotorhülse 163 unter Ausbildung eines radialen Holweck-Spalts 171 gegenüber und bildet mit dieser die der Turbomolekularpumpen nachfolgende erste Holweck-Pumpstufe. Die radiale Innenfläche der äußeren Holweck-Rotorhülse 163 steht der radialen Außenfläche der inneren Holweck-Statorhülse 169 unter Ausbildung eines radialen Holweck-Spalts 173 gegenüber und bildet mit dieser eine zweite Holweck-Pumpstufe. Die radiale Innenfläche der inneren Holweck-Statorhülse 169 liegt der radialen Außenfläche der inneren Holweck-Rotorhülse 165 unter Ausbildung eines radialen Holweck-Spalts 175 gegenüber und bildet mit dieser die dritte Holweck-Pumpstufe.

Am unteren Ende der Holweck-Rotorhülse 163 kann ein radial verlaufender Kanal vorgesehen sein, über den der radial außenliegende Holweck-Spalt 171 mit dem mittleren Holweck-Spalt 173 verbunden ist. Außerdem kann am oberen Ende der inneren Holweck-Statorhülse 169 ein radial verlaufender Kanal vorgesehen sein, über den der mittlere Holweck-Spalt 173 mit dem radial innenliegenden Holweck-Spalt 175 verbunden ist. Dadurch werden die ineinander geschachtelten Holweck-Pumpstufen in Serie miteinander geschaltet. Am unteren Ende der radial innenliegenden Holweck-Rotorhülse 165 kann ferner ein Verbindungskanal 179 zum Auslass 117 vorgesehen sein.

Die vorstehend genannten pumpaktiven Oberflächen der Holweck-Statorhülsen 163, 165 weisen jeweils mehrere spiralförmig um die Rotationsachse 151 herum in axialer Richtung verlaufende Holweck-Nuten auf, während die gegenüberliegenden Mantelflächen der Holweck-Rotorhülsen 163, 165 glatt ausgebildet sind und das Gas zum Betrieb der Vakuumpumpe 111 in den Holweck-Nuten vorantreiben.

Zur drehbaren Lagerung der Rotorwelle 153 sind ein Wälzlager 181 im Bereich des Pumpenauslasses 117 und ein Permanentmagnetlager 183 im Bereich des Pumpeneinlasses 115 vorgesehen.

Im Bereich des Wälzlagers 181 ist an der Rotorwelle 153 eine konische Spritzmutter 185 mit einem zu dem Wälzlager 181 hin zunehmenden Außendurchmesser vorgesehen. Die Spritzmutter 185 steht mit mindestens einem Abstreifer eines Betriebsmittelspeichers in gleitendem Kontakt. Der Betriebsmittelspeicher umfasst mehrere aufeinander gestapelte saugfähige Scheiben 187, die mit einem Betriebsmittel für das Wälzlager 181, z.B. mit einem Schmiermittel, getränkt sind.

Im Betrieb der Vakuumpumpe 111 wird das Betriebsmittel durch kapillare Wirkung von dem Betriebsmittelspeicher über den Abstreifer auf die rotierende Spritzmutter 185 übertragen und in Folge der Zentrifugalkraft entlang der Spritzmutter 185 in Richtung des größer werdenden Außendurchmessers der Spritzmutter 185 zu dem Wälzlager 181 hin gefördert, wo es z.B. eine schmierende Funktion erfüllt. Das Wälzlager 181 und der Betriebsmittelspeicher sind durch einen wannenförmigen Einsatz 189 und den Lagerdeckel 145 in der Vakuumpumpe eingefasst.

Das Permanentmagnetlager 183 umfasst eine rotorseitige Lagerhälfte 191 und eine statorseitige Lagerhälfte 193, welche jeweils einen Ringstapel aus mehreren in axialer Richtung aufeinander gestapelten permanentmagnetischen Ringen 195, 197 umfassen. Die Ringmagnete 195, 197 liegen einander unter Ausbildung eines radialen Lagerspalts 199 gegenüber, wobei die rotorseitigen Ringmagnete 195 radial außen und die statorseitigen Ringmagnete 197 radial innen angeordnet sind. Das in dem Lagerspalt 199 vorhandene magnetische Feld ruft magnetische Abstoßungskräfte zwischen den Ringmagneten 195, 197 hervor, welche eine radiale Lagerung der Rotorwelle 153 bewirken. Die rotorseitigen Ringmagnete 195 sind von einem Trägerabschnitt 201 der Rotorwelle 153 getragen, welcher die Ringmagnete 195 radial außenseitig umgibt. Die statorseitigen Ringmagnete 197 sind von einem statorseitigen Trägerabschnitt 203 getragen, welcher sich durch die Ringmagnete 197 hindurch erstreckt und an radialen Streben 205 des Gehäuses 119 aufgehängt ist. Parallel zu der Rotationsachse 151 sind die rotorseitigen Ringmagnete 195 durch ein mit dem Trägerabschnitt 203 gekoppeltes Deckelelement 207 festgelegt. Die statorseitigen Ringmagnete 197 sind parallel zu der Rotationsachse 151 in der einen Richtung durch einen mit dem Trägerabschnitt 203 verbundenen Befestigungsring 209 sowie einen mit dem Trägerabschnitt 203 verbundenen Befestigungsring 211 festgelegt. Zwischen dem Befestigungsring 211 und den Ringmagneten 197 kann außerdem eine Tellerfeder 213 vorgesehen sein.

Innerhalb des Magnetlagers ist ein Not- bzw. Fanglager 215 vorgesehen, welches im normalen Betrieb der Vakuumpumpe 111 ohne Berührung leer läuft und erst bei einer übermäßigen radialen Auslenkung des Rotors 149 relativ zu dem Stator in Eingriff gelangt, um einen radialen Anschlag für den Rotor 149 zu bilden, da eine Kollision der rotorseitigen Strukturen mit den statorseitigen Strukturen verhindert wird. Das Fanglager 215 ist als ungeschmiertes Wälzlager ausgebildet und bildet mit dem Rotor 149 und/oder dem Stator einen radialen Spalt, welcher bewirkt, dass das Fanglager 215 im normalen Pumpbetrieb außer Eingriff ist. Die radiale Auslenkung, bei der das Fanglager 215 in Eingriff gelangt, ist groß genug bemessen, sodass das Fanglager 215 im normalen Betrieb der Vakuumpumpe nicht in Eingriff gelangt, und gleichzeitig klein genug, sodass eine Kollision der rotorseitigen Strukturen mit den statorseitigen Strukturen unter allen Umständen verhindert wird.

Die Vakuumpumpe 111 umfasst den Elektromotor 125 zum drehenden Antreiben des Rotors 149. Der Anker des Elektromotors 125 ist durch den Rotor 149 gebildet, dessen Rotorwelle 153 sich durch den Motorstator 217 hindurch erstreckt. Auf den sich durch den Motorstator 217 hindurch erstreckenden Abschnitt der Rotorwelle 153 kann radial außenseitig oder eingebettet eine Permanentmagnetanordnung angeordnet sein. Zwischen dem Motorstator 217 und dem sich durch den Motorstator 217 hindurch erstreckenden Abschnitt des Rotors 149 ist ein Zwischenraum 219 angeordnet, welcher einen radialen Motorspalt umfasst, über den sich der Motorstator 217 und die Permanentmagnetanordnung zur Übertragung des Antriebsmoments magnetisch beeinflussen können.

Der Motorstator 217 ist in dem Gehäuse innerhalb des für den Elektromotor 125 vorgesehenen Motorraums 137 festgelegt. Über den Sperrgasanschluss 135 kann ein Sperrgas, das auch als Spülgas bezeichnet wird, und bei dem es sich beispielsweise um Luft oder um Stickstoff handeln kann, in den Motorraum 137 gelangen. Über das Sperrgas kann der Elektromotor 125 vor Prozessgas, z.B. vor korrosiv wirkenden Anteilen des Prozessgases, geschützt werden. Der Motorraum 137 kann auch über den Pumpenauslass 117 evakuiert werden, d.h. im Motorraum 137 herrscht zumindest annäherungsweise der von der am Pumpenauslass 117 angeschlossenen Vorvakuumpumpe bewirkte Vakuumdruck.

Zwischen der Rotornabe 161 und einer den Motorraum 137 begrenzenden Wandung 221 kann außerdem eine sog. und an sich bekannte Labyrinthdichtung 223 vorgesehen sein, insbesondere um eine bessere Abdichtung des Motorraums 217 gegenüber den radial außerhalb liegenden Holweck-Pumpstufen zu erreichen.

Wie eingangs bereits erläutert wurde, ist eine möglichst großflächige NEG-Beschichtung der mit dem Vakuum in Kontakt stehenden Oberflächen des Geräts erstrebenswert, um eine maximale - aktive und passive - Wirkung der Beschichtung zu erhalten. Auch eine (teilweise) Beschichtung von der Pumpe 111 vorgelagerten Komponenten (z.B. des Rezipients) ist denkbar. Gute Resultate sind jedoch oft bereits erzielbar, wenn nur einzelne Komponenten oder Bereiche der Pumpe 111 beschichtet sind.

Insbesondere kann das Innere des Gehäuses 119 ganz oder teilweise beschichtet sein. Besonders wirkungsvoll ist eine Beschichtung des Gehäuses 119 im Bereich des Einlasses 115 und/oder der dort angeordneten Elemente (z.B. Streben 205, Trägerabschnitt 203). Auch die Komponenten der turbomolekularen Pumpstufen (insbesondere die Rotorscheiben 155, die Statorscheiben 157 und die Abstandsrings 159) können ganz oder teilweise beschichtet sein. Gerade eine Beschichtung der eingangsseitigen Pumpstufen (beispielweise der ersten beiden Pumpstufen) erzielt deutliche Effekte.

Eine NEG-Beschichtung im Bereich der Holweck-Pumpstufen, insbesondere der pumpaktiven Oberflächen, steigert die Effizienz der Pumpe 111 zusätzlich.

Für andere Vakuumgeräte, z.B. Sensoren, Messgeräte und Ventile, gelten grundsätzlich die gleichen Überlegungen wie die, die vorstehend in Zusammenhang mit der Pumpe 111 dargelegt wurden.

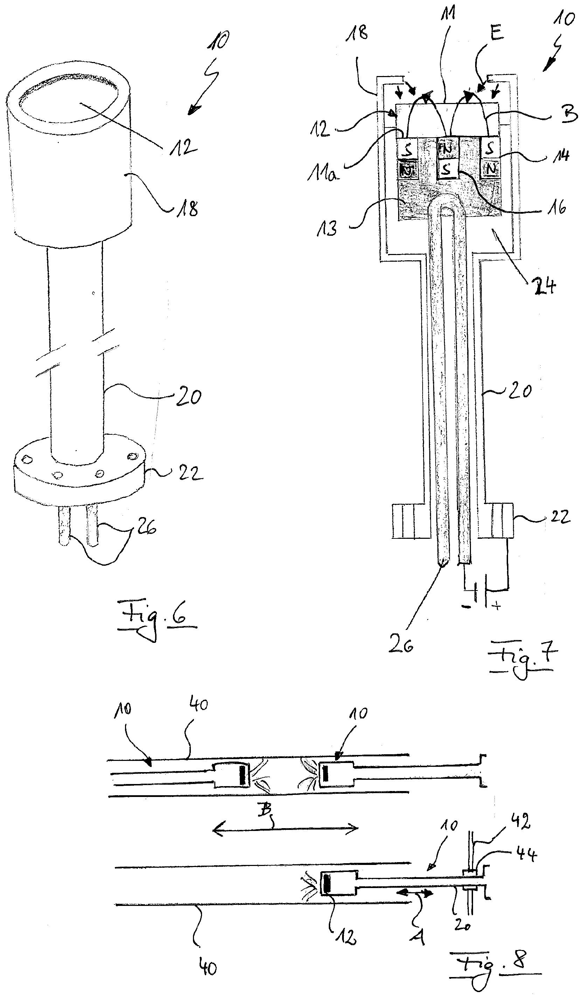

Die Funktionsweise eines in Fig. 6 gezeigten und insbesondere zur Beschichtung rohrförmiger Bauteile geeigneten Magnetronsputterkopfes 10 lässt sich anhand der Schnittzeichnung Fig. 7 nachvollziehen. Der Kopf 10 umfasst ein Target 12 aus vorlegiertem NEG-Material mit einer im Wesentlichen ebenen Targetoberfläche 11. An einer Rückseite 11a des Targets 12 befinden sich - eingebettet in eine Basis 13 - ein Ringmagnet 14 (oben Südpol S, unten Nordpol) und ein Zylindermagnet 16 (oben N, unten S). Die durch die Magnetanordnung 14, 16 erzeugten magnetischen Feldlinien B verlaufen vom Nordpol N des Zylindermagneten 16 zum Südpol (S) des Ringmagneten 14 und umgekehrt.

Das Target 12 dient als Kathode (-) und ein Erdungsschild 18, das die Basis 13 und das Target 12 umschließt, als Anode (+) der Sputteranordnung. Das Erdungsschild 18 ist über ein Rohr 20 (Lanze) und einen Flansch 22 mit dem Gehäuse der Beschichtungsanlage verbunden und befindet sich auf Erdpotenzial. Erdungsschild 18 und Target 20 sind von einander nichtleitend isoliert, beispielsweise durch eine Isolierung 24.

Zwischen beiden Elektroden (Schild 18 einerseits; Target 12, Basis 13 andererseits) liegt Hochspannung (HV) im Bereich 300 V bis 1200 V an. Dadurch wird zwischen Target 12 und dem Erdungsschild 18 ein starkes elektrisches Feld E generiert. Durch kosmische Strahlung erzeugt Elektronen und - nach Zündung des Plasmas (siehe unten) - Sekundärelektronen aus der Kathode (Schild 18) streben zur Anode (Target 12) und werden durch die Wirkung des E- und B-Felds auf Spiralbahnen (Vektorprodukt ExB) zwischen der Kathode und der Anode gezwungen.

Eine Vakuumkammer, die auf einen Restgasdruck von 10⁻⁶ mbar abgepumpt wurde, wird bei aktivierter HV mit Edelgas bis zu einem Druck von 10⁻² mbar geflutet. Bei diesem Druck zündet bei gegebener Hochspannung (1200V) durch die vorhandenen freien Elektronen ein Argon-Ionen-Plasma, was auch durch das Paschen-Gesetz beschrieben ist. Die positiven Argon-Ionen werden von dem elektrischen Feld von dem Schild 18 weg und damit zu dem Target 12 hin beschleunigt. Sie prallen auf das Target 12 und zerstäuben das Targetmaterial. Das Targetmaterial lagert sich im Anschluss überall - auch auf dem zu beschichtenden Substrat - ab, so dass dort ein Dünnschichtfilm entsteht.

Nach erfolgter Plasmazündung wird der Edelgasdruck in einen Bereich von 10⁻³ mbar reduziert. Die dadurch geringere Thermalisierung der abgedampften Targetatome hat eine höhere Sputterrate sowie eine höhere Qualität der Schicht (Haftung, Dichte, Reinheit) zur Folge. Es konnte gezeigt werden, dass die Zusammensetzung der Beschichtung (abgelagertes Targetmaterial) zu 100% mit der Zusammensetzung des Targets 12 übereinstimmt.

Durch das Rohr 20 (Lanze) führen zwei Kupferrohre 26, durch die Kühlwasser zur Kühlung der Basis 13 und damit letztlich auch des Targets 12 fließt. Die Kühlung des Targetmaterials, das durch die Plasmaentladung mit einer Leistungsdichte von etwa 5W/cm² permanent aufgeheizt wird, erfolgt nämlich über die Basis 13 an der Targetrückseite 11a. Die Basis 13 kann ein Kupferblock sein. Er dient sowohl zur Targethalterung als auch zur effektiven Kühlung. Er kann eine Mehrzahl von Kühlkanälen aufweisen, um eine möglichst gleichmäßige Kühlwirkung bereitstellen zu können.

Die Kupferrohre 26 sind über die als Kühlkörper fungierende Basis 13 elektrisch leitend mit dem Target 12 verbunden. Die negative Hochspannung, die am Ende der Kupferrohre 26 angelegt ist, liegt damit auch am Target 12.

Die Abmessungen des Sputterkopfs 10 könne in Abhängigkeit von dem zu beschichtenden Substrat gewählt werden, z.B. wird der Außendurchmesser des Kopfes 10 an den Innendurchmesser eines von Innen zu beschichtenden Rohrs angepasst. Dies hat eine Optimierung der Sputterrate, der Haftung, der Materialgüte sowie der Prozessdauer zur Folge.

Es versteht sich, dass der Kopf 10 und/oder das Target 12 auch eine nichtkreisförmige Geometrie aufweisen können. Auch ellipsenförmige, quadratische, rechteckige oder polygonale Geometrien sind denkbar.

Prinzipiell können mit dieser Technik alle Arten von Substraten (Metalle, Halbleiter und Nichtleiter) mit NEG beschichtet werden.

Um die Haftung der Beschichtung auf dem Substrat zu steigern, werden vor der Beschichtung mit NEG letzte Wasserrückstände/-filme (typischerweise Filmdicken von 10-100 Angstrom) mittels Ionenbeschuss entfernt. Dieses Verfahren ist deutlich schonender und zeitsparender als das thermische Ausheizen des Substrats bei Temperaturen um 300°C.

Zum Beschichten eines ausgedehnten Substrats 40 kann es vorgesehen sein, das Substrat 40 (hier beispielhaft ein Rohr) und den Kopf 10 relativ zueinander zu verfahren (siehe Fig. 8). Dies kann durch Verfahren des Sputterkopfes 10 erfolgen (siehe Pfeil A). Dabei ist das Substrat 40 in einer Beschichtungskammer angeordnet. Das Rohr 20 des Kopfs 10 wird durch eine Vakuumdurchführung 44 in einer Wand 42 der Beschichtungskammer geführt. Eine Bewegung des Rohrs 20 führt zu einer Bewegung des Targets 12 relativ zu dem Substrat 40. Alternativ kann das Substrat 40 innerhalb der Beschichtungskammer mittels eines Schienentransportsystems relativ zu einem stationär angeordneten Kopf 10 bewegt werden (siehe Pfeil B). Dieses Verfahren hat den Vorteil, dass keine Schiebdurchführungen 44 in der Kammerwand 42 benötigt wird. Es versteht sich, dass auch der Kopf 10 verfahrbar in der Kammer angeordnet sein kann. Dann können sowohl das Substrat 40 als auch der Kopf 10 bewegt werden.

Zur Beschleunigung des Beschichtungsvorgangs ist es auch möglich, statt nur einem Sputterkopf 10 (Fig. 8, unten) zwei Sputterköpfe 10 (Fig. 8, oben) zu verwenden, die in die jeweiligen Rohrenden hineinragen. Durch den zeitgleichen Betrieb beider Sputterköpfe kann die Beschichtungszeit halbiert werden.

Die vorstehenden Ausführungen gelten in analoger Form für das Beschichten von planaren Substraten mittels eines Verfahrens, dass eine Relativbewegung des Substrats und des Targets vorsieht.

## Patentansprüche

1. Turbomolekularpumpe mit zumindest einem Bauteil, das einen Abschnitt aufweist, der bei einem Betrieb der Turbomolekularpumpe mit einem Vakuum in Kontakt steht und der zumindest abschnittsweise mit einer Gasteilchen absorbierenden Schicht beschichtet ist, und zwar mit einer Schicht eines non-evaporable getter (NEG) Materials, **dadurch gekennzeichnet, dass** die Schicht eine Mischung von Titan, Zirkonium und Vanadium umfasst, die Titan und Vanadium zu in etwa gleich großen Anteilen umfasst und weniger Zirkonium als Titan oder Vanadium enthält.

2. Turbomolekularpumpe nach Anspruch 1,
dadurch g e k e n n z e ichn e t , dass
die Schicht nur Titan, Zirkon und/oder Vanadium umfasst.

3. Turbomolekularpumpe nach Anspruch 1 oder 2,
dadurch g e k e n n z e ichn e t , dass
Titan, Zirkonium und Vanadium in einem Mischungsverhältnis von etwa 34:32:34 vorliegen.

4. Turbomolekularpumpe nach zumindest einem der vorstehenden Ansprüche,
dadurch **gekennzeichet**, dass
das Bauteil ein bei Betrieb der Turbomolekularpumpe statisches Bauteil ist, insbesondere ein Gehäuse und/oder ein mit einem Gehäuse fest verbundenes Bauteil.

5. Turbomolekularpumpe nach zumindest einem der Ansprüche 1 bis 3,
**dadurch gekennzeichnet , dass**
das Bauteil ein bei Betrieb der Turbomolekularpumpe zu einer Bewegung antreibbares Bauteil ist.

6. Turbomolekularpumpe nach zumindest einem der vorstehenden Ansprüche,
**dadurch gekennzeichnet, dass**
das Bauteil ein eine Pumpwirkung erzeugendes Bauteil ist.

7. Turbomolekularpumpe nach zumindest einem der vorstehenden Ansprüche,
**dadurch gekennzeichnet, dass**
ein Einlassbereich und/oder in dem Einlassbereich angeordnete Komponenten der Turbomolekularpumpe zumindest abschnittsweise mit der Schicht beschichtet sind.

8. Verfahren zum NEG-Beschichten von Bauteilen einer Turbomolekularpumpe nach einem der Ansprüche 1 bis 7, durch einen Sputterprozess, insbesondere durch Magnetronsputtern,
bei dem wenigstens ein nicht-drahtförmiges Target verwendet wird.

9. Verfahren zum NEG-Beschichten von Bauteilen einer Turbomolekularpumpe nach einem der Ansprüche 1 bis 7, durch einen Sputterprozess, insbesondere durch Magnetronsputtern,
bei dem das Target und das Bauteil während des Sputterprozesses relativ zueinander bewegt werden.

10. Verfahren nach Anspruch 8 oder 9,
**dadurch gekennzeichnet,**
**dass** ein Target verwendet wird, dass eine zumindest abschnittsweise ebene Targetoberfläche aufweist.

11. Verfahren nach einem der Ansprüche 8 bis 10,
**dadurch gekennzeichnet,**
**dass** das beschichtete Bauteil ein rohrförmiges Bauteil ist.

12. Verfahren nach Anspruch 11,
**dadurch gekennzeichnet,**
**dass** das Target während des Sputterprozesses derart relativ zu dem rohrförmigen Bauteil orientiert ist, dass der äußere Rand des Targets in einer senkrecht zur Längsachse des rohrförmigen Bauteils verlaufenden Ebene liegt.

13. Verfahren nach einem der Ansprüche 8 bis 12,
**dadurch gekennzeichnet,**
**dass** ein planares Target oder ein wenigstens eine ebene Oberfläche aufweisendes Target verwendet wird, insbesondere wobei mittels des planaren Targets oder mittels des wenigstens eine ebene Oberfläche aufweisenden Targets ein abschnittsweise ebenes oder plattenförmiges Bauteil beschichtet wird.

14. Verfahren zum Betreiben einer Turbomolekularpumpe nach einem der Ansprüche 1 bis 7,
bei dem zumindest das mit der NEG-Beschichtung versehene Bauteil vor der bestimmungsgemäßen Verwendung des Vakuumgerätes durch Erhitzen aktiviert wird.

15. Verfahren nach Anspruch 14,
**dadurch gekennzeichnet,**
**dass** das Bauteil auf zumindest im Wesentlichen 200°C erhitzt wird, insbesondere wobei das Bauteil über einen Zeitraum von zumindest im Wesentlichen 24 Stunden auf einer Temperatur gehalten wird, die zumindest im Wesentlichen 200°C beträgt.

## Claims

1. A turbomolecular pump having at least one component that has a section which is in contact with a vacuum in an operation of the turbomolecular pump and which is at least sectionally coated with a film absorbing gas particles, and indeed with a film of a non-evaporable getter (NEG) material, **characterized in that**
the film comprises a mixture of titanium, zirconium and vanadium, the mixture comprising titanium and vanadium in approximately equal portions and containing less zirconium than titanium or vanadium.

2. A turbomolecular pump according to claim 1,
**characterized in that**
the film comprises only titanium, zirconium and/or vanadium.

3. A turbomolecular pump according to claim 1 or 2,
**characterized in that**
titanium, zirconium, and vanadium are present in a mixing ratio of approximately 34:32:34.

4. A turbomolecular pump in accordance with at least one of the preceding claims,
**characterized in that**
the component is a component which is static in operation of the turbomolecular pump, in particular a housing and/or a component fixedly connected to a housing.

5. A turbomolecular pump in accordance with at least one of the claims 1 to 3, **characterized in that**
the component is a component which can be driven to make a movement in operation of the turbomolecular pump.

6. A turbomolecular pump in accordance with at least one of the preceding claims,
**characterized in that**
the component is a component generating a pump effect.

7. A turbomolecular pump in accordance with at least one of the preceding claims,
**characterized in that**
an inlet region and/or components of the turbomolecular pump arranged in the inlet region is/are at least sectionally coated with the film.

8. A method of NEG coating components of a turbomolecular pump in accordance with any one of the claims 1 to 7 by a sputtering process, in particular by magnetron sputtering,
in which method at least one non-wire shaped target is used.

9. A method of NEG coating components of a turbomolecular pump in accordance with any one of the claims 1 to 7 by a sputtering process, in particular by magnetron sputtering,
in which method the target and the component are moved relative to one another during the sputtering process.

10. A method in accordance with claim 8 or 9,
**characterized in that**
a target is used that has an at least sectionally planar target surface.

11. A method in accordance with any one of the claims 8 to 10,
**characterized in that**
the coated component is a tubular component.

12. A method in accordance with claim 11,
**characterized in that**
the target is oriented relative to the tubular component during the sputtering process such that the outer margin of the target is disposed in a plane extending perpendicular to the longitudinal axis of the tubular component.

13. A method in accordance with any one of the claims 8 to 12,
**characterized in that**
a planar target or a target having at least one planar surface is used, in particular with a sectionally planar or plate-like component being coated by means of the planar target or by means of the target having at least one planar surface.

14. A method of operating a turbomolecular pump in accordance with any one of the claims 1 to 7,
in which at least the component that is provided with the NEG coating is activated by heating before the use of the vacuum device in accordance with its intended purpose.

15. A method in accordance with claim 14,
**characterized in that**
the component is heated to at least substantially 200°C, in particular with the component being held at a temperature which at least substantially amounts to 200°C over a time period of at least substantially 24 hours.

## Revendications

1. Pompe turbomoléculaire comprenant au moins un composant qui présente une partie qui, lors du fonctionnement de la pompe turbomoléculaire, est en contact avec le vide et qui est recouverte au moins localement d'une couche absorbant les particules de gaz, à savoir d'une couche d'un matériau getter non-évaporable (NEG),
**caractérisée en ce que**
la couche comprend un mélange de titane, de zirconium et de vanadium, qui contient du titane et du vanadium en proportions à peu près égales et qui contient moins de zirconium que de titane ou de vanadium.

2. Pompe turbomoléculaire selon la revendication 1,
**caractérisée en ce que**
la couche ne contient que du titane, du zirconium et/ou du vanadium.

3. Pompe turbomoléculaire selon la revendication 1 ou 2,
**caractérisée en ce que**
le titane, le zirconium et le vanadium sont présents dans un rapport de mélange d'environ 34 : 32 : 34.

4. Pompe turbomoléculaire selon l'une au moins des revendications précédentes,
**caractérisée en ce que**
le composant est un composant statique lors du fonctionnement de la pompe turbomoléculaire, en particulier un carter et/ou un composant relié solidairement à un carter.

5. Pompe turbomoléculaire selon l'une au moins des revendications 1 à 3,
**caractérisée en ce que**
le composant est un composant pouvant être entraîné en mouvement pendant le fonctionnement de la pompe turbomoléculaire.

6. Pompe turbomoléculaire selon l'une au moins des revendications précédentes,
**caractérisée en ce que**
le composant est un composant produisant un effet de pompage.

7. Pompe turbomoléculaire selon l'une au moins des revendications précédentes,
**caractérisée en ce que**
une zone d'admission et/ou des composants de la pompe turbomoléculaire disposés dans la zone d'admission sont recouverts au moins localement de ladite couche.

8. Procédé de revêtement NEG de composants d'une pompe turbomoléculaire selon l'une des revendications 1 à 7 par un processus de pulvérisation cathodique, en particulier par pulvérisation cathodique magnétron,
qui utilise au moins une cible non filiforme.

9. Procédé de revêtement NEG de composants d'une pompe turbomoléculaire selon l'une des revendications 1 à 7 par un processus de pulvérisation cathodique, en particulier par pulvérisation cathodique magnétron,
dans lequel la cible et le composant sont déplacés l'un par rapport à l'autre pendant le processus de pulvérisation cathodique.

10. Procédé selon la revendication 8 ou 9,
**caractérisé en ce que**
le procédé utilise une cible qui présente une surface au moins localement plane.

11. Procédé selon l'une des revendications 8 à 10,
**caractérisé en ce que**
le composant revêtu est un composant tubulaire.

12. Procédé selon la revendication 11,
**caractérisé en ce que**
pendant le processus de pulvérisation cathodique, la cible est orientée par rapport au composant tubulaire de telle sorte que le bord extérieur de la cible se trouve dans un plan perpendiculaire à l'axe longitudinal du composant tubulaire.

13. Procédé selon l'une des revendications 8 à 12,
**caractérisé en ce que**
le procédé utilise une cible planaire ou une cible présentant au moins une surface plane, en particulier, la cible planaire ou la cible présentant au moins une surface plane permet de revêtir un composant localement plan ou en forme de plaque.

14. Procédé pour faire fonctionner une pompe turbomoléculaire selon l'une des revendications 1 à 7,
dans lequel au moins le composant pourvu du revêtement NEG est activé par chauffage avant l'utilisation prévue de l'appareil à vide.

15. Procédé selon la revendication 14,
**caractérisé en ce que**
le composant est chauffé à au moins sensiblement 200 °C,
en particulier, pendant une période d'au moins sensiblement 24 heures, le composant est maintenu à une température qui est au moins sensiblement de 200 °C.
